# EUROPÄISCHE PATENTANMELDUNG

(11) **EP 0 862 063 A1**
(43) Veröffentlichungstag der Anmeldung: **02.09.1998**
(21) Anmeldenummer: 97103272.7
(22) Anmeldetag: 27.02.1997
(51) Int. Cl.: G01R 31/3185

(54) **Schnittstellen-Steuerung einer Test-Schnittstelle**

(71) Anmelder: SIEMENS AKTIENGESELLSCHAFT, 80333 München (DE)
(72) Erfinder: Ulf, Pillkahn, 81475 München (DE)

(57) **Zusammenfassung**

Der Erfindung liegt die Aufgabe zugrunde, eine universelle Test-Schnittstelle zu ermöglichen, die den Aufwand bei der Entwicklung zur Funktionsprüfung minimiert. Dieses Aufgabe wird durch eine Schnittstellen-Steuerung (SEL) gelöst, die eingangsseitig eine JTAG-Schnittstelle bildet und ausgangsseitig einerseits eine JTAG-Schnittstelle bildet und andererseits eine serielle Schnittstelle.

## Beschreibung

Der normale Fertigungs- und Prüfablauf von Vermittlungssystemen und vermutlich auch anderer großer Systeme sieht nach einer Baugruppenprüfung (ICT + evtl. BOST) und der Bestückung des Gestellrahmens einen Funktionstest (entweder unter Systembedingungen oder speziellen Testbedingungen) vor.

Durch die Vielzahl von Gestellrahmen und die Vielzahl der Varianten der Bestückung einerseits und die unterschiedliche Gestaltung der Schnittstellen des Prüflings andererseits gibt es bisher keine Möglichkeit, über nur eine einzige Schnittstelle auf die Prüflinge zuzugreifen. Vielmehr mußte bisher für jeden neuen Prüfling eine neue individuelle Lösung erarbeitet werden. Mit der Entwicklung und Wartung verschiedener Prüfsysteme ist jedoch ein enormer Aufwand verbunden, wobei dem eigentlichen Prüfprogramm wesentlich größere Aufmerksamkeit geschenkt werden müßte.

Die Anforderungen vom Testengineering werden besonders auf die zusätzlichen Kosten hin untersucht, da nach der Fertigungsprüfung die prüfspezifisch vorgeleisteten Merkmale brachliegen. Für die verschiedenen Systeme bzw. Subsysteme wurde jeweils eine individuelle Lösung entwickelt. Durch die oben beschriebene Vielfalt ist die Adaptierung des Prüfgerätes jeweils eine neue Herausforderung.

Folgende Lösungen sind bis heute im Einsatz:
- Prüfung über Systemschnittstellen (MB(B), SN(B), CCNC, CCG, SYP, LTGK, LTGM, SMSC(B,C)),
- Prüfung über V.24-Schnittstelle (ACC, DLUV (geplant), LTGN (geplant),
- Prüfung über Mikroprozessorbus (LTGG, LTGC(B), DLU).

Der Erfindung liegt die Aufgabe zugrunde, mit Hilfe einer Schnittstellen-Steuerung eine universelle Test-Schnittstelle zu schaffen, die den Aufwand bei der Entwicklung zur Funktionsprüfung minimiert.

Diese Aufgabe wird durch eine Schnittstellen-Steuerung gemäß Anspruch 1 gelost.

Durch die erfindungsgemäße Schnittstellen-Steuerung läßt sich ein Universalprüfgerät (Gerät+universelle Schnittstelle) realisieren, das allein durch verschiedene Softwarelösungen an die unterschiedlichen Prüflinge angepaßt werden kann.

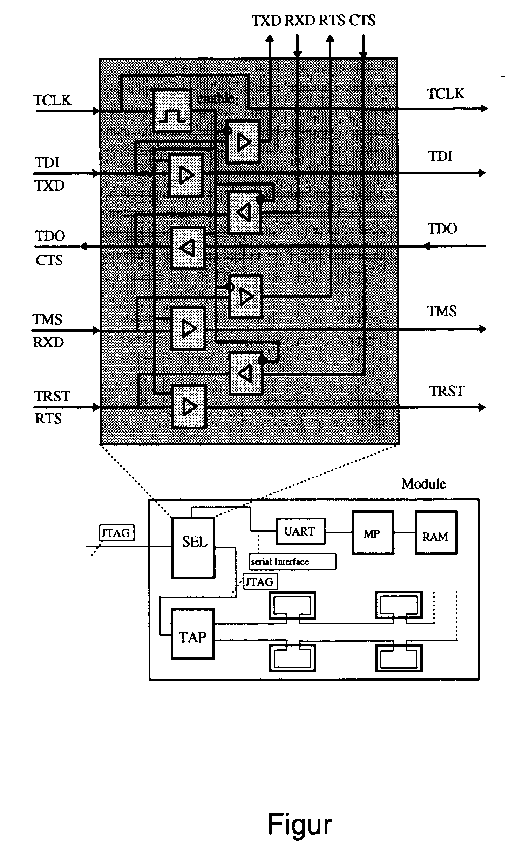

Im folgenden wird ein Ausführungsbeispiel der Erfindung anhand der Zeichnung, die eine Figur umfaßt, naher erläutert.

Ähnlich der in der Baugruppenprüfung für Boundary-Scan verwendeten und standardisierten JTAG-Schnittstelle wird für die Funktionsprüfung eine ähnliche Schnittstelle (sogenannte erweiterte JTAG-Schnittstelle) verwendet.

Da sich die JTAG-Schnittstelle inzwischen durchgesetzt hat und davon auszugehen ist, daß zumindest auf den Gruppenprozessoren der Systeme/Subsysteme eine solche implementiert ist, ist eine erweiterte Verwendung der Schnittstelle für die Funktionsprüfung somit sehr vorteilhaft.

Die JTAG-Schnittstelle ist eine serielle Schnittstelle, die aus 4 bzw. 5 Signalen besteht. Wie im Standard 1149.1 beschrieben, gibt es jeweils einen Dateneingang und einen Datenausgang. Die anderen Signale dienen der Steuerung. Da die Baugruppenprüfung und die Funktionsprüfung nicht simultan ablaufen, können die Signale TDI und TDO für eine serielle Schnittstelle ähnlich der V.24-Schnittstelle benutzt werden. Eine Unterscheidung zwischen Baugruppenprüfung und Funktionsprüfung kann man z.B. über das Steuersignal TCLK erreichen.

Die Figur zeigt ein Beispiel einer erfindungsgemäßen Schnittstellen-Steuerung SEL sowie deren Einbindung in eine Baugruppe.

### Funktionsweise:

Die Datensignale am Controller TAP sind taktzustandsgesteuert, das serielle Interface ist flankengesteuert. Durch die unterschiedliche Synchronisation der Daten ist das Auskoppeln der Daten je nach Anwendungsfall möglich. Das Taktsignal ist der entscheidende Punkt. Liegt der Takt an, entsteht am Monoflop am Ausgang High-Potential und alle Signale werden a la JTAG durchgeschaltet. Liegt kein Takt an, führt der Monoflop Ausgang Low-Potential. Die Treiber werden entsprechend dem enable Signal geschaltet und die vier Signale werden als serielles Interface mit den Signalen TXD, RXD, CTS, RTS durchgeschaltet.

Die Schnittstellen-Steuerung SEL kann in einem Baustein realisiert werden. In diesen Baustein könnte noch der UART (Universal Asynchronous Receiver/Transmitter) als seriell/parallel Wandler und Schnittstelle zum Mikroprozessorsystem MP integriert werden.

Über die Schnittstellen-Steuerung SEL kann das Prüfprogramm geladen und dann auch gesteuert werden.

Es gibt mehrere Vorteile dieser Lösung:
- Es sind keine zusätzlichen Pins notwendig.
- Der zusätzliche Hardware-Aufwand zur Anbindung der Schnittstelle an das Prozessorsystem kann ähnlich dem TAP-Controller in einem ASIC implementiert werden und steht damit in jeder neuen Anwendung in der Bibliothek zur Verfügung.
- Der gleiche Mechanismus zum Auskoppeln der Signale ist auch beim Einspeisen anwendbar.
- Die Schnittstellen-Steuerung ließe sich auch für andere Zwecke verwenden, für die z.B. die JTAG-Schnittstelle zu langsam ist.
- Eine geplante V.24 könnte ebenfalls entfallen.

Die Besonderheit der SEL liegt in der Kombination der standardisierten JTAG-Schnittstelle und einer üblichen seriellen Verbindung. Da sich die JTAG-Schnittstelle als Standard etabliert hat, bestehen gute Chancen in Richtung Universalität der erweiterten JTAG-Schnittstelle zur Steuerung der Funktionsprüfung.

## Patentansprüche

1. Schnittstellen-Steuerung einer Test-Schnittstelle,
**dadurch gekennzeichnet, daß**
die Schnittstellen-Steuerung (SEL) eingangsseitig eine JTAG-Schnittstelle bildet und ausgangsseitig, gesteuert durch ein Steuersignal der eingangsseitigen JTAG-Schnittstelle, einerseits eine JTAG-Schnittstelle bildet und andererseits eine serielle Schnittstelle.

2. Schnittstellen-Steuerungs-Baustein,
**gekennzeichnet durch**
eine Schnittstellen-Steuerung (SEL) nach Anspruch 1.

3. Schnittstellen-Steuerungs-Baustein nach Anspruch 2,
**gekennzeichnet durch**
einen UART, der die Schnittstelle zum Mikroprozessor-System bildet.

4. ASIC,
**gekennzeichnet durch**
eine Schnittstellen-Steuerung (SEL) nach Anspruch 1.
